# EUROPÄISCHE PATENTSCHRIFT

(11) **EP 3 066 898 B1**
(45) Veröffentlichungstag und Bekanntmachung des Hinweises auf die Patenterteilung: **23.08.2017**
(21) Anmeldenummer: 14795937.3
(22) Anmeldetag: 09.10.2014
(51) Int. Cl.: H05K 1/02, H01R 12/52, H05K 3/46

(54) **LEITERPLATTENSTRUKTUR**
PRINTED CIRCUIT BOARD
CIRCUIT IMPRIMÉ

(30) Priorität: 07.11.2013 AT 8572013; 05.03.2014 AT 501632014
(43) Veröffentlichungstag der Anmeldung: 14.09.2016
(73) Patentinhaber: AT & S Austria Technologie & Systemtechnik Aktiengesellschaft, 8700 Leoben (AT)
(72) Erfinder: KASPER, Alexander, 8055 Graz (AT); SCHULZ, Gernot, 8020 Graz (AT); SHIVARUDRAPPA, Ravi Hanyal, 570 002 Mysore Karnataka (IN); MAIER, Markus, 8020 Graz (AT)
(74) Vertreter: Patentanwaltskanzlei Matschnig & Forsthuber OG
(86) Internationale Anmeldenummer: PCT/AT2014/050238
(87) Internationale Veröffentlichungsnummer: WO 2015/066742

(56) Entgegenhaltungen:
- EP-A1- 1 722 612
- DE-A1-102004 019 431
- US-A1- 2008 304 237
- US-A1- 2009 091 020
- US-A1- 2012 031 652

## Beschreibung

Die Erfindung bezieht sich auf eine Leiterplattenstruktur mit zumindest einer dielektrischen Isolierschicht und zumindest einer Leiterschicht.

Die Verteilung entstehender Wärme und das Kühlen von Bauteilen in einer Leiterplatte, kurz gesagt, dass thermische Management, ist ein immer mehr in den Vordergrund tretendes Problem. Aufgrund des Umstands, dass die Oberflächen einer Leiterplatte eine immer größere Anzahl von Bauteilen, insbesondere ICs aufnehmen muss und diese Bauteile immer mehr Hitze aufgrund beispielsweise einer hohen funktionalen Integration innerhalb der Chips entwickeln, muss trotz der auftretenden Wärme die Funktionalität der Bauteile, z. B. der ICs, gewährleistet bleiben, um Probleme bei den Kunden zu vermeiden, wobei als Beispiel die Problematik sehr heiß werdender Mobiltelefone an einem Ohr des Benutzers genannt sei. Es ist bekannt, dass erzeugte Wärme, dort wo es möglich ist, über sogenannte thermische Vias zu Wärmesenken transportiert wird, d. s. Elemente, die sich an der Oberfläche der Leiterplatte befinden und die dann aktiv oder passiv, z. B. mit Hilfe eines Ventilators gekühlt werden können.

Die Herstellung solcher thermischen Vias ist jedoch kosten- und zeitaufwändig und oft können solche thermischen Vias nicht in unmittelbarer Nähe der Wärmequelle erstellt werden, was deren Wirkung vermindert. Als Stand der Technik sind die in den Dokumenten US-A1-2012/0031652 und DE-A1-102004019431 beschriebenen Leiterplattenstrukturen gemäss dem Oberbegriff von Anspruch 1 bekannt. Es ist demnach eine Aufgabe der Erfindung, eine Leiterplattenstruktur zu schaffen, die ein besseres Wärmemanagement bietet und die günstiger in der Herstellung ist.

Diese Aufgabe wird einer Leiterplattenstruktur gelöst, bei welcher erfindungsgemäß innerhalb der zumindest einen Isolierschicht eine Schicht aus einem dielektrischen wärmeleitenden Material vorgesehen ist, die sich zumindest in Nähe oder in Kontakt mit einer inneren Leiterbahnstruktur befindet.

Dank der Erfindung ergibt sich eine günstige Herstellung von Leiterplatten, bei welchen die Wärme von stark erwärmten Bereichen abgeführt oder verteilt werden soll, und überdies wird das Erscheinungsbild der Leiterplatte nicht geändert, d. h. die Abmessungen und insbesondere die Dicke können gleich bleiben. Außerdem lässt sich die Leiterplattenstruktur mit herkömmlichen Leiterplatten-Herstellungsverfahren produzieren. Die Erfindung bietet ihre besonderen Vorteile bei mobilen Vorrichtungen, wie mobilen Telefonen, mobilen Rechnern, in der Automobilindustrie sowie in medizinischen und anderen industriellen Produkten.

Zur noch besseren Verteilung und Abführung anfallender Wärme kann vorgesehen sein, dass in unmittelbarer Nähe oder in Kontakt mit der Schicht aus einem dielektrischen wärmeleitenden Material eine weitere wärmeleitende Schicht vorgesehen ist. In den meisten Anwendungsfällen ist in bevorzugter Weise die weitere wärmeleitende Schicht eine elektrisch leitende Metallschicht.

Zur effizienten und raschen Abführung von Wärme in das Innere der Struktur kann vorteilhafterwiese vorgesehen sein, dass eine zumindest wärmeleitende Durchkontaktierung von einem an der Leiterplatte außen liegenden Leiterabschnitt in das Leiterplatteninnere zumindest in die Nähe der Schicht aus einem dielektrischen wärmeleitenden Material geführt ist. Besonders zweckmäßig ist es in diesem Fall, wenn die wärmeleitende Durchkontaktierung elektrisch leitfähig ist, zu einer inneren Leiterbahn geführt ist und mit dieser elektrisch in Kontakt steht.

Eine weitere Verbesserung der Wärmeverwaltung lässt sich erreichen, wenn eine Durchkontaktierung von einem Leiterabschnitt zu einem von diesem in Abstand liegenden Leiterabschnitt geführt ist, wobei diese Durchkontaktierung auch zumindest in Nähe der Schicht aus einem dielektrischen wärmeleitenden Material verläuft. Dabei kann es auch vorteilhaft sein, wenn die Durchkontaktierung mit einer inneren Leiterbahnstruktur in Verbindung steht. In vielen Fällen ist es auch empfehlenswert, wenn die Durchkontaktierung von einer äußeren Leiterschicht an einer Seite zu einer äußeren Leiterschicht an der gegenüber liegenden Seite geführt ist.

Einen besonders guten Wärmeübergang erhält man, wenn die Schicht aus einem dielektrischen wärmeleitenden Material Zwischenräume der inneren Leiterbahnstruktur ausfüllt.

Die Erfindung samt weiteren Vorteilen ist im Folgenden unter Bezugnahme auf die angefügten Zeichnungen anhand beispielsweiser Ausführungen näher erläutert. In diesen zeigen:
Fig. 1 bis 4 in schematischen Teilschnitten die Herstellung und den Aufbau einer ersten Ausführungsform der Erfindung,
Fig. 5 bis 10 in schematischen Teilschnitten die Herstellung und den Aufbau einer zweiten Ausführungsform der Erfindung,
Fig. 11 bis 15 in schematischen Teilschnitten die Herstellung und den Aufbau einer dritten Ausführungsform der Erfindung,
Fig. 16 bis 23 in schematischen Teilschnitten die Herstellung und den Aufbau einer vierten Ausführungsform der Erfindung,
Fig. 24 bis 26 in schematischen Teilschnitten die Herstellung und den Aufbau einer fünften Ausführungsform der Erfindung und
Fig. 27 als sechste Ausführungsform der Erfindung in einem Schnitt eine Variante der in Fig. 26 gezeigten Ausführungsform.

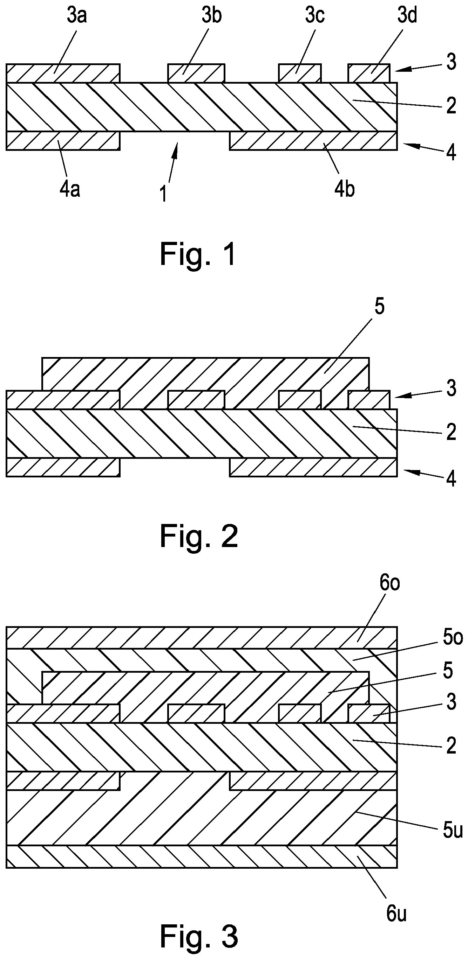

Zunächst wird unter Bezugnahme auf die Fig. 1 bis 4 die Herstellung einer ersten Ausführungsform der Erfindung beschrieben. Dabei ist der Ausgangspunkt eine in Fig. 1 dargestellte Leiterplatte 1, die aus einer Isolierschicht 2, z B. eine Prepreg, und einer oberen Leiterbahnstruktur 3 mit hier eingezeichneten Leiterbahnen 3a bis 3d sowie einer unteren Leiterbahnstruktur 4 mit hier eingezeichneten Leiterbahnen 4a und 4b. Die Leiterplatte 1 ist im Allgemeinen vorgefertigt und besitzt dann bereits ein geätztes Kupferbild. In einem nächsten Schritt gemäß Fig. 2 wird nun eine Schicht 5 aus einem wärmeleitfähigen dielektrischen Material auf die obere Leiterbahnstruktur aufgebracht, wobei Zwischenräume zwischen einzelnen Leiterbahnen gleichfalls mit diesem wärmeleitfähigen dielektrischen Material 5 ausgefüllt sind. Für ein derartiges wärmeleitfähiges Material kommen beispielsweise keramikgefüllte Pasten, Kohlenstoff-Nano-Tubes in Frage, wobei die Aufbringungsverfahren unterschiedlich sein können.

Ein bevorzugtes Verfahren sind Druckverfahren, z. B. Siebdruck, Schablonendruck oder andere Druckverfahren, doch können andere Verfahren zum Aufbringen des wärmeleitfähigen Materials verwendet werden. Das wärmeleitfähige Material kann auch mit einem anderen Verfahren vollflächig aufgebracht werden, wobei ein nachträgliches Strukturieren vorteilhaft sein kann, falls das Material nicht vollflächig gewünscht ist bzw. es mit den üblichen Druckverfahren nicht möglich ist, ein möglicherweise technisch aufwändiges Design zu drucken. Man kann dann das wärmeleitfähige Material mit Hilfe eines üblichen Druckverfahrens vollflächig auftragen und Vorhärten (entsprechend dem sogenannten "B-staging" von Epoxidharzen, wie FR 4). Sodann kann mit einem in der Leiterplattenherstellung üblichen fotolithographischen Prozess ein Strukturieren vorgenommen werden, wobei z.B. das Belichten mit einer Filmmaskierung oder durch LDI (Laser Direct Imaging) erfolgt. In der Folge wird entwickelt, nach Wegwaschen mit geeigneten Chemikalien die Strukturierung erhalten und das Material vollständig ausgehärtet. Das Härten erfolgt mit Hilfe üblicher Härtungsmethoden, wie z.B. thermisches Härten, UV- oder IR-Härten, Anwendung von Laserstrahlung etc.

Die Schichtdicken der wärmeleitfähigen Materialien liegen im Besondern im Bereich von 5 µm bis 100 µm und die Wärmeleitfähigkeiten je nach dem Material liegen zwischen 1 W/mK und 20 W/mK.

In einem nächsten Schritt gemäß Fig. 3 wird der vorhandene Aufbau nach Fig. 2 durch weitere Schichten aus Prepregs und Kupferfolien ergänzt, nämlich hier durch eine obere Schicht 5o eines Dielektrikums und einer untere Schicht 5u eines Dielektrikums, wobei diese Schichten 5o und 5u durch eine Kupferschicht 6o bzw. 6u abgedeckt werden, z. B. durch Kupferfolien. An dieser Stelle sei angemerkt, dass sich die Begriffe "oben" und "unten" nur auf die Darstellungen in den Zeichnungen beziehen und zur Erleichterung der Beschreibung verwendet werden.

In einem letzten Schritt werden die obere Leiterschicht 6o und die untere Leiterschicht 6u noch in gewünschter Weise strukturiert, sodass sich in der Zeichnung einzelne Leiterbahnen 6oa, 6ob und 6ua, 6ub und 6uc ergeben. Die Schicht 5 aus wärmeleitfähigem Material ermöglichst es nun, Wärme, die im vorliegenden Fall z. B. durch eine Erwärmung der Leiterbahnen 3b oder 3c entsteht, von diesen Leiterbahnen abzuführen und zu verteilen, so dass weder im Inneren, noch an der Oberfläche der so erhaltenen Leiterplattenstruktur 7 übermäßige Wärme - sogenannte "Hot Spots" - entsteht.

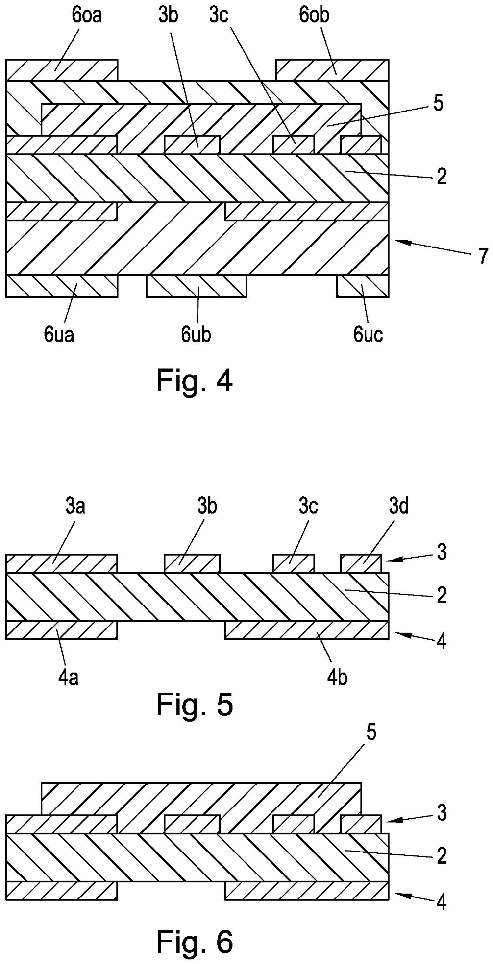

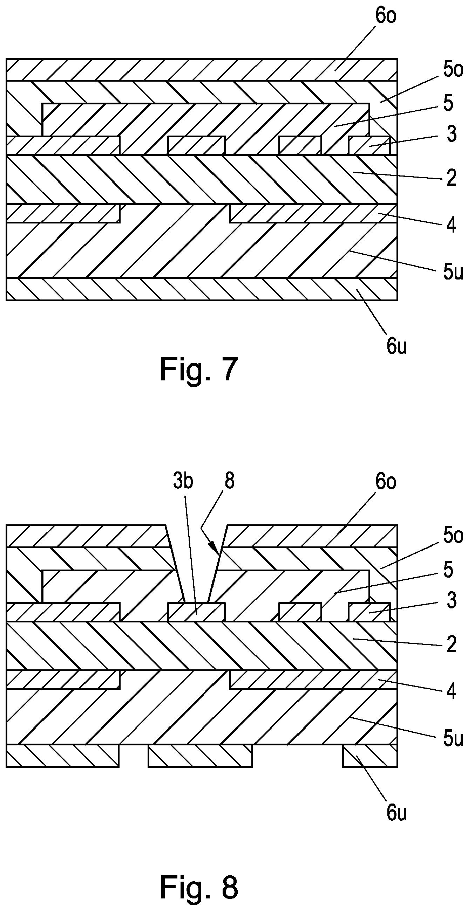

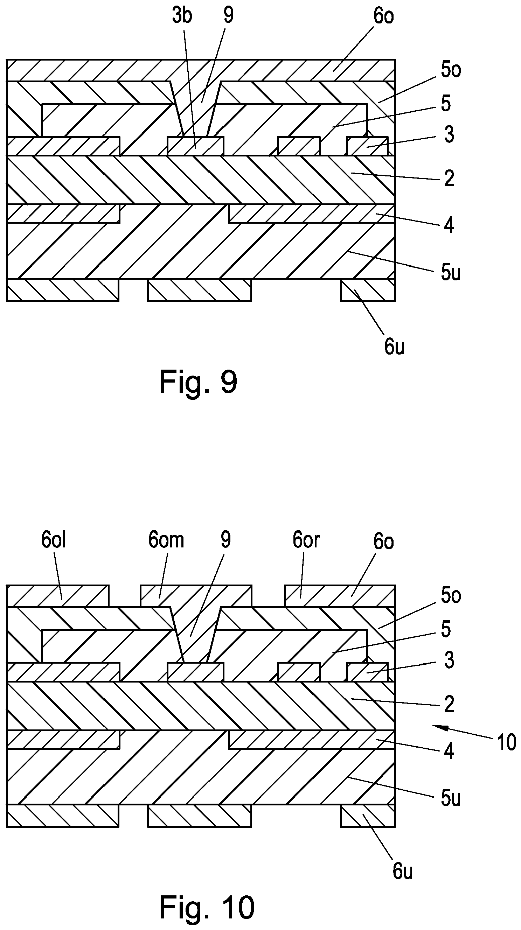

Eine Variante der Erfindung wird nun anhand der Fig. 5 bis 10 erläutert, wobei für vergleichbare Teile gleiche Bezugszeichen verwendet werden und die Fig. 5 bis 7 den Fig. 1 bis 3 entsprechen, da bis zu diesem Punkt der Herstellungsprozess der gleiche wie zuvor beschrieben ist. Ausgehend von dem Aufbau nach Fig. 7 wird nun eine Laserbohrung 8 von oben bis zur Leiterbahn 3b erzeugt, wobei die angewendeten Verfahren in der Leiterplattenherstellung bekannt sind. Üblicherweise wird zunächst die obere Kupferschicht 6o mit einer der in der Leiterplattenindustrie üblichen Laserbohrverfahren, wie Standard UV/CO₂-Laser, Copper Direct CO2-Laser etc. gebohrt. Nach fertig gestellter Bohrung 8 erfolgt eine Verkupferung, beispielsweise durch einen galvanischen Prozess, wodurch ein Via 9 (Vertical interconnect access, Durchkontaktierung) von der oberen Kupferbahn 6o zu der Kupferbahn 3b erzeugt wird (siehe Fig. 9). Anschließend wird mit einem gleichfalls in der Leiterplattenindustrie üblichen Verkupferungsprozess auf die für den nachfolgenden Strukturierungsprozess benötigte Kupferstärke verkupfert. Anstelle eines derartig hergestellten Vias kann auch eine mechanische Durchkontaktierung von der Oberseite zur Unterseite hergestellt werden.

Danach kann die obere Kupferbahn strukturiert werden und man erhält die fertige Leiterplattenstruktur 10, gemäß Fig. 10. Bei der hier dargestellten Ausführungsform kann insbesondere Wärme von der in Fig. 10 mittleren oberen Leiterbahn 6om, die beispielsweise entsteht, wenn an dieser Leiterbahn ein Chip mit einem Pad sitzt, ins Innere der Leiterbahn gebracht werden, wobei sie dort durch die wärmeleitende Schicht 5, die als dielektrische Schicht, d. h. isolierend ausgebildet ist, verteilt wird. Dadurch vermeidet man eine exzessive Erwärmung an der Oberfläche der Struktur 10.

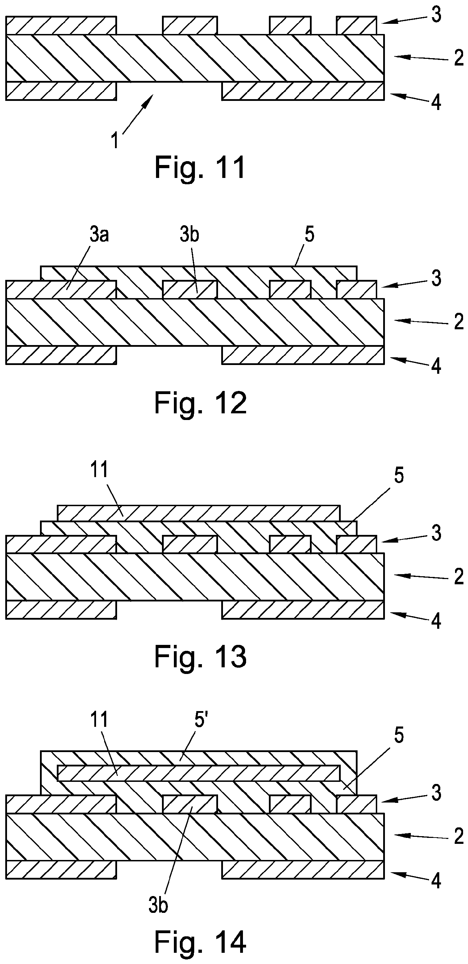

Anhand der Fig. 11 bis 15 wird nun eine weitere Variante einer erfindungsgemäßen Leiterplattenstruktur beschrieben, wobei wiederum gleiche Bezugszeichen für gleiche Teile verwendet werden. Die Fig. 11 und 12 bedürfen keiner weiteren Erläuterung, da sie den Fig. 1 und 2 entsprechen. Ausgehend von dem nun in Fig. 12 vorliegenden Aufbau wird nun auf die wärmeleitende dielektrische Schicht 5 eine weitere wärmeleitende, insbesondere eine elektrisch leitende metallische Schicht 11, beispielsweise durch ein Druckverfahren aufgebracht. In einem nächsten Schritt, dessen Ergebnis aus Fig. 14 ersichtlich ist, wird diese Metallschicht 11 mit Hilfe einer Schicht 5' aus wärmeleitendem dielektrischen Material ummantelt. Die Metallschicht 11 ist somit in ein wärmeleitendes Dielektrikum 5, 5' eingebettet. Die Schicht 11 muss nicht notwendigerweise aus einem reinen Metall bestehen, es könnten auch Metallverbindungen, wie z.B. Aluminiumnitrid, oder Metallkeramiken Verwendung finden.

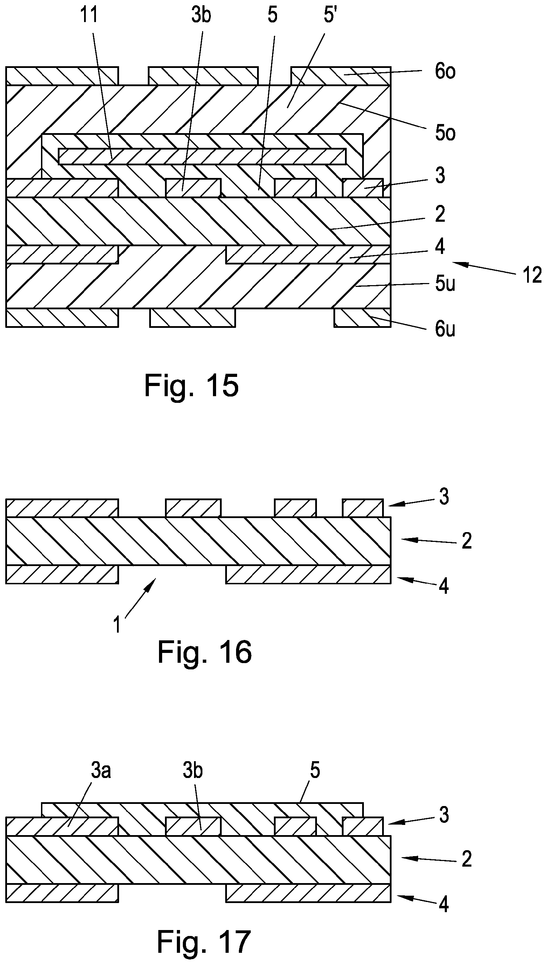

In einem weiteren Schritt werden nun die wärmeleitenden dielektrischen Schichten 5o und 5u, sowie Leiterschichten 6o und 6u, vergleichbar mit Fig. 3, aufgebracht und strukturiert, sodass man eine fertige Leiterplattenstruktur 12 erhält, wie in Fig. 15 dargestellt. Wie bereits erwähnt, können herkömmliche, den Fachmann auf dem Gebiet der Leiterplattenherstellung bekannte Verfahren zur Herstellung solcher Strukturen angewendet werden, nämlich insbesondere das Verpressen von Prepreg-Lagen, deren Material je nach dem gewünschten Anwendungsgebiet gewählt wird, das galvanische Aufbringen von Metallschichten sowie das Aufbringen von Metallschichten durch Druckverfahren. Im Falle einer galvanischen Aufbringung der Leiterschichten 6o und 6u können diese anschließend mittels eines Maskierungsprozesses strukturiert werden. Bei Varianten dieser Ausführung kann das Verfahren auch im Sinne eines doppelseitigen Aufbaues durchgeführt werden, bei welchem auch in der unteren Schicht 5u eine Metallschicht in eine wärmeleitendes Dielektrikum eingebettet ist, oder es kann der zweite Schritt des Druckens der wärmeleitenden dielektrischen Schicht entfallen.

Wieder eine andere Ausführungsform wird nun anhand der Fig. 16 bis Fig. 23 erläutert. Die Leiterplatte 1 in Fig. 16 entspricht wiederum der Leiterplatte 1 nach Fig. 1 oder Fig. 11 und sinngemäß gleiches gilt für den Aufbau nach Fig. 17, welcher beispielsweise jenem nach Fig. 12 entspricht. In ähnlicher Weise, wie in Fig. 13 dargestellt, wird bei dieser Ausführungsform eine Metallschicht 11 aufgebracht, die hier jedoch eine Ausnehmung 11a besitzt. In einem nächsten Schritt wird, vergleichbar mit Fig. 14 eine zusätzliche Schicht 5' aus einem dielektrischen wärmeleitenden Material zur Ummantelung der Metallschicht 11 aufgebracht, z. B. aufgedruckt.

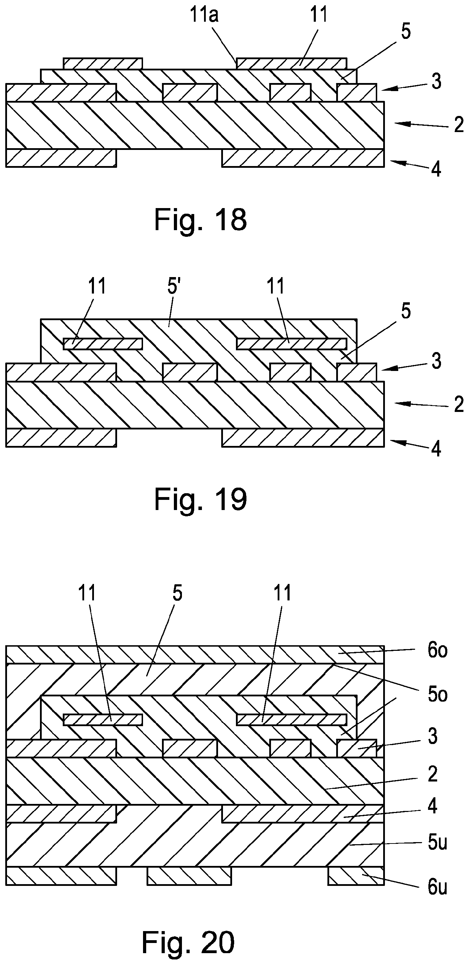

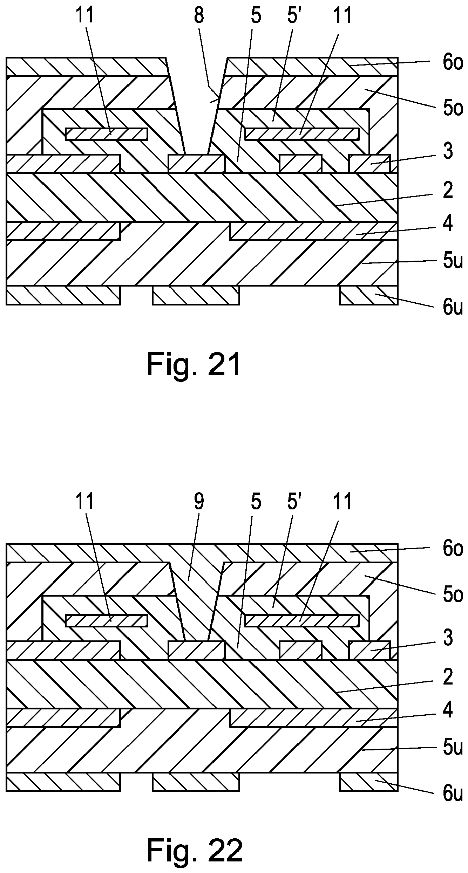

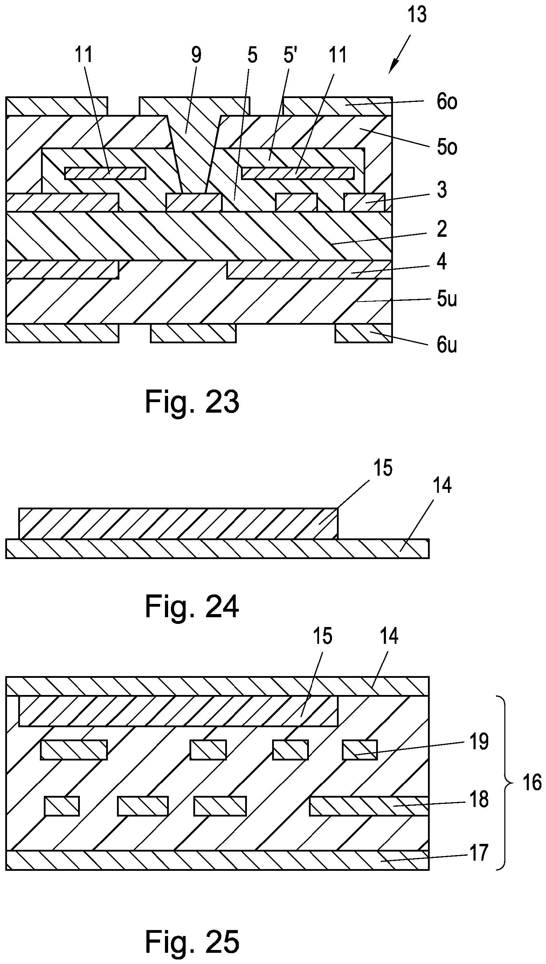

Der Aufbau nach Fig. 19 wird nun durch Verpressen mit einer oberen und unteren dielektrischen Schicht 5o, 5u und Leiterschichten 6o, 6u ergänzt, wobei das Ergebnis in Fig. 20 gezeigt ist. Daraufhin wird, siehe Fig. 21, eine Laserbohrung 8 (vergleiche auch Fig. 8) hergestellt und, wie in Fig. 22 dargestellt, ein Via 9 (vergleiche Fig. 9) durch einen stromlosen und galvanischen Prozess hergestellt. Nach einer Strukturierung der oberen und der unteren Leiterschicht 6o und 6u (im vorliegenden Fall war die untere Leiterschicht 6u bereits strukturiert) liegt die Leiterplattenstruktur 13 gemäß Fig. 23 vor, die sich durch die Kombination der dielektrischen wärmeleitfähigen Schichten 5, 5' mit der Metallschicht 11 und dem Via 9 auszeichnet. Hier kann beispielsweise Wärme, die in dem Leiterzug 3c entsteht, verwaltet, d. h, zweckmäßig verteilt, werden und ebenso Wärme, die in den Leiterzug 6om, beispielsweise durch einen auf diesem Leiterzug sitzenden Chip entsteht, abgeführt werden, nämlich in das Innere der Struktur 13. Alle was in Zusammenhang mit den vorgehend beschriebenen Beispielen zur Herstellung und Strukturierung der diversen verwendeten Schichten gesagt wurde, gilt in gleicher Weise für dieses und auch das folgende Beispiel. Auch bei dieser Ausführung kann das Verfahren im Sinne eines doppelseitigen Aufbaues durchgeführt werden.

Unter Bezugnahme auf die Fig. 24 bis 26 wird nun noch ein Ausführungsbeispiel der Erfindung erläutert. Auf eine dünne Leiterschicht 14, nämlich eine Kupferfolie, wird eine Schicht 15 aus wärmeleitfähigem dielektrischen Material aufgedruckt, wobei die Schicht 15 strukturiert oder vollflächig aufgebracht werden und allfällig später strukturiert werden kann. Der Druck erfolgt dabei auf der sogenannten "treatment"-Seite (innere Seite) der Kupferfolie. Es erfolgt ein Härten mit einem der bereits erwähnten bekannten Verfahren.

Dieser Aufbau, bestehend aus den Schichten 14 und 15, wird nun mit einer vorgefertigten und teils strukturierten Leiterplatte 16, beispielsweise durch Einpressen in der in Fig. 25 gezeigten Art verbunden, wobei nun die Kupferfolie 14 mit der Schicht 15 gegenüber der Fig. 24 umgedreht ist. Man erhält einen Aufbau nach Fig. 25, bei welchem die bei diesem verwendete Leiterplatte 16 ein Dielektrikum, z. B. ein Prepreg, mit einer unteren Leiterschicht 17, und zwei innen liegenden, strukturierten Leiterschichten 18 und 19 besitzt.

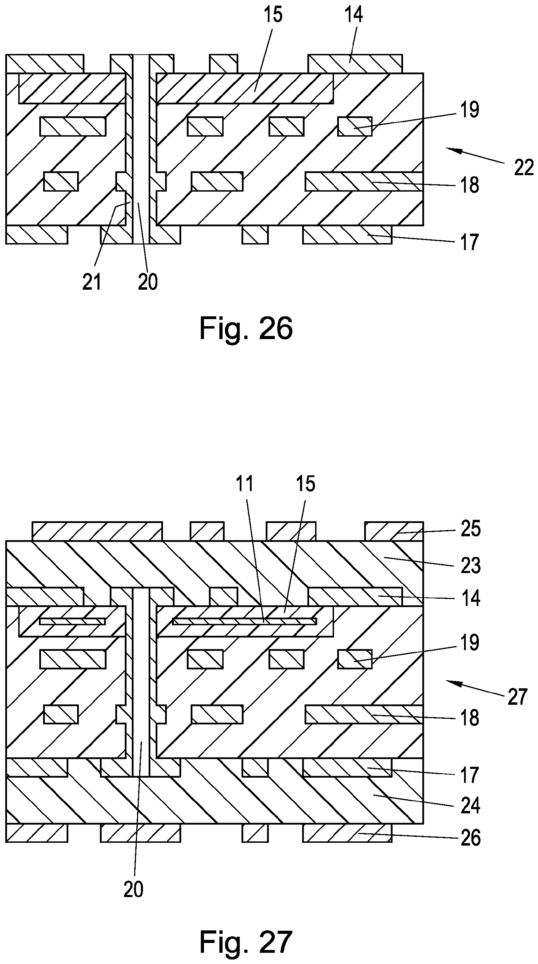

In einem folgenden Schritt, dessen Ergebnis in Fig. 26 gezeigt ist, wird eine den gesamten Aufbau durchsetzende Bohrung 20, beispielsweise mechanisch oder mit Hilfe einer Lasereinrichtung hergestellt. Außerdem werden die Leiterschichten 14 und 17 strukturiert. Die Schritte der Herstellung des Bohrens und der Strukturierung können auch vertauscht werden Die Bohrung 20 verbindet nun einen Leiterbahn-Abschnitt der oberen Leiterschicht 14 und einen Leiterbahn-Abschnitt der unteren Leiterschicht 17 und wird durch einen Verkupferungsvorgang innen mit einer leitenden Kupferschicht 21 versehen, welche Leiterbahn-Abschnitte der Leiterschichten 14, 18, 17 elektrisch und wärmeleitend miteinander verbindet. Bei dieser Ausführung kann Wärme, die beispielsweise am oberen Ende der Bohrung 20 in einen Abschnitt der Leiterschicht 14 eingebracht wird, in das Innere der so erhaltenen Leiterplattenstruktur 22 eingebracht und verteilt werden.

Schließlich zeigt Fig. 27 eine Variante, ausgehend von Fig. 26, bei welcher noch zusätzliche dielektrische Schichten 23 und 24 sowie Leiterschichten 25 und 26 auf den Aufbau nach Fig. 27 aufgebracht sind. Überdies ist bei dieser mit 27 bezeichneten Leiterplattenstruktur eine Metallschicht 11, wie beispielsweise in Fig. 23, in der Schicht 15 aus wärmeleitfähigem dielektrischen Material vorgesehen, was zu einer verbesserten Wärmeverteilung führt. Bei der Struktur 27 kann Wärme entweder im Bereich der Bohrung 20 entstehen oder beispielsweise an einer Leiterbahn der strukturierten Leiterschicht 14.

Es sollte schließlich klar sein, dass die Darstellungen der Figuren 1 bis 27 im Allgemeinen nur Ausschnitte aus einer größeren Leiterplattenstruktur zeigen, und in der Praxis verschiedene Varianten kombiniert sein können. Beispielsweise könnte die Variante nach Fig. 27 neben einer Bohrung 20 auch ein eine Durchkontaktierung 9 besitzen.

## Patentansprüche

1. Leiterplattenstruktur (7,10,12,13,22,27) mit zumindest zwei dielektrischen Isolierschichten (2, 5o, 5u, 23, 24) und zumindest einer Leiterschicht (3, 4, 6o, 6u, 14, 25, 26),
**dadurch gekennzeichnet, dass**
lagenweise innerhalb der Leiterplattenstruktur (7, 10, 12, 13, 22, 27) zwischen den zumindest zwei Isolierschichten (5o, 5u, 23, 24) eine Schicht (5, 15) aus einem dielektrischen wärmeleitenden Material angeordnet ist, die sich wärmeleitend zumindest in Nähe oder in wärmeleitendem Kontakt mit einer inneren Leiterbahnstruktur (3,14, 21) befindet.

2. Leiterplattenstruktur (7, 10, 12, 13, 22, 27) nach Anspruch 1, **dadurch gekennzeichnet, dass** wärmeleitend in unmittelbarer Nähe oder in wärmeleitendem Kontakt mit der Schicht (5, 15) aus einem dielektrischen wärmeleitenden Material eine weitere wärmeleitende Schicht (11) vorgesehen ist.

3. Leiterplattenstruktur (7, 10, 12, 13, 22, 27) nach Anspruch 2, **dadurch gekennzeichnet, dass** die weitere wärmeleitende Schicht eine elektrisch leitende Metallschicht (11) ist.

4. Leiterplattenstruktur (7, 10, 12, 13, 22, 27) nach einem der Ansprüche 1 bis 3, **dadurch gekennzeichnet, dass** eine zumindest wärmeleitende Durchkontaktierung (9) von einem an einer Leiterplatte (1) außen liegenden Leiterabschnitt (6om) in das Leiterplatteninnere zumindest in wärmeleitende Nähe der Schicht (5) aus einem dielektrischen wärmeleitenden Material geführt ist.

5. Leiterplattenstruktur (7, 10, 12, 13, 22, 27) nach Anspruch 4, **dadurch gekennzeichnet, dass** die wärmeleitende Durchkontaktierung (9) elektrisch leitfähig ist, zu einer inneren Leiterbahn (3b) geführt ist und mit dieser elektrisch in Kontakt steht.

6. Leiterplattenstruktur (7, 10, 12, 13, 22, 27) nach einem der Ansprüche 1 bis 5, **dadurch gekennzeichnet, dass** eine Durchkontaktierung (21, 20) von einem Leiterabschnitt (14) zu einem von diesem in Abstand liegenden Leiterabschnitt (17) geführt ist, wobei diese Durchkontaktierung (21, 20) auch zumindest in wärmeleitender Nähe der Schicht (5, 15) aus einem dielektrischen wärmeleitenden Material verläuft.

7. Leiterplattenstruktur (7, 10, 12, 13, 22, 27) nach Anspruch 6, **dadurch gekennzeichnet, dass** die Durchkontaktierung (21, 20) mit einer inneren Leiterbahnstruktur (18) in Verbindung steht.

8. Leiterplattenstruktur (7, 10, 12, 13, 22, 27) nach Anspruch 6 oder 7, **dadurch gekennzeichnet, dass** die Durchkontaktierung (21,20) von einer äußeren Leiterschicht (14) an einer Seite einer Leiterplatte (16) zu einer äußeren Leiterschicht (17) an der gegenüber liegenden Seite der Leiterplatte (16) geführt ist.

9. Leiterplattenstruktur (7, 10, 12, 13, 22, 27) nach einem der Ansprüche 1 bis 8, **dadurch gekennzeichnet, dass** die Schicht (5, 15) aus einem dielektrischen wärmeleitenden Material Zwischenräume der inneren Leiterbahnstruktur (3) ausfüllt.

## Claims

1. A printed circuit board structure (7, 10, 12, 13, 22, 27) with at least two dielectric insulating layers (2, 5o, 5u, 23, 24) and at least one conductive layer (3, 4, 6o, 6u, 14, 25, 26),
**characterized in that**
in layers within the printed circuit board structure (7, 10, 12, 13, 22, 27), the at least two insulating layers (5o, 5u, 23, 24) have, arranged between them, a layer (5, 15) made of a dielectric thermally conductive material that is located thermally conductively at least in the vicinity of, or in thermally conductive contact with, an inner conductor track structure (3, 14, 21).

2. The printed circuit board structure (7, 10, 12, 13, 22, 27) according to claim 1, **characterized in that** thermally conductively in the immediate vicinity of, or in thermally conductive contact with, the layer (5, 15) made of a dielectric thermally conductive material, another thermally conductive layer (11) is provided.

3. The printed circuit board structure (7, 10, 12, 13, 22, 27) according to claim 2, **characterized in that** the other thermally conductive layer is an electrically conductive metal layer (11).

4. The printed circuit board structure (7, 10, 12, 13, 22, 27) according to any of claims 1 to 3, **characterized in that** an at least thermally conductive feedthrough (9) passes from a conductor section (6om) lying on the outside of a printed circuit board (1) into the inside of the printed circuit board, at least into the thermally conductive vicinity of the layer (5) made of a dielectric thermally conductive material.

5. The printed circuit board structure (7, 10, 12, 13, 22, 27) according to claim 4, **characterized in that** the thermally conductive feedthrough (9) is electrically conductive, passes to an inner conductor track (3b), and makes electrical contact with the latter.

6. The printed circuit board structure (7, 10, 12, 13, 22, 27) according to any of claims 1 to 5, **characterized in that** a feedthrough (21, 20) passes from one conductor section (14) to another conductor section (17) lying at a distance from the first one, this feedthrough (21, 20) also running at least in the thermally conductive vicinity of the layer (5, 15) made of a dielectric thermally conductive material.

7. The printed circuit board structure (7, 10, 12, 13, 22, 27) according to claim 6, **characterized in that** the feedthrough (21, 20) is connected with an inner conductor track structure (18).

8. The printed circuit board structure (7, 10, 12, 13, 22, 27) according to claim 6 or 7, **characterized in that** the feedthrough (21, 20) passes from an outer conductive layer (14) on one side of a printed circuit board (16) to an outer conductive layer (17) on the opposite side of the printed circuit board (16).

9. The printed circuit board structure (7, 10, 12, 13, 22, 27) according to any of claims 1 to 8, **characterized in that** the layer (5, 15) made of a dielectric thermally conductive material fills spaces within the inside conductor track structure (3).

## Revendications

1. - Structure de carte à circuits imprimés (7, 10, 12, 13, 22, 27) ayant au moins deux couches isolantes diélectriques (2, 5o, 5u, 23, 24) et au moins une couche conductrice (3, 4, 6o, 6u, 14, 25, 26),
**caractérisée par le fait que**
en couches à l'intérieur de la structure de carte à circuits imprimés (7, 10, 12, 13, 22, 27) entre les au moins deux couches isolantes (5o, 5u, 23, 24) est disposée une couche (5, 15) faite d'un matériau thermoconducteur diélectrique, qui se trouve de façon thermoconductrice au moins au voisinage de, ou en contact thermoconducteur avec, une structure de piste conductrice interne (3, 14, 21).

2. - Structure de carte à circuits imprimés (7, 10, 12, 13, 22, 27) selon la revendication 1, **caractérisée par le fait que** de façon thermoconductrice au voisinage immédiat de, ou en contact thermoconducteur avec, la couche (5, 15) faite d'un matériau thermoconducteur diélectrique est prévue une autre couche thermoconductrice (11).

3. - Structure de carte à circuits imprimés (7, 10, 12, 13, 22, 27) selon la revendication 2, **caractérisée par le fait que** l'autre couche thermoconductrice est une couche métallique (11) conductrice de l'électricité.

4. - Structure de carte à circuits imprimés (7, 10, 12, 13, 22, 27) selon l'une des revendications 1 à 3, **caractérisée par le fait qu'**un trou d'interconnexion au moins thermoconducteur (9) passe d'une section conductrice (6om) située à l'extérieur sur une carte à circuits imprimés (1) dans l'intérieur de la carte à circuits imprimés, au moins au voisinage thermoconducteur de la couche (5) faite d'un matériau thermoconducteur diélectrique.

5. - Structure de carte à circuits imprimés (7, 10, 12, 13, 22, 27) selon la revendication 4, **caractérisée par le fait que** le trou d'interconnexion thermoconducteur (9) est conducteur de l'électricité, passe dans une piste conductrice interne (3b) et réalise un contact électrique avec celle-ci.

6. - Structure de carte à circuits imprimés (7, 10, 12, 13, 22, 27) selon l'une des revendications 1 à 5, **caractérisée par le fait qu'**un trou d'interconnexion (21, 20) passe d'une section conductrice (14) à une section conductrice (17) située à distance de celle-ci, ce trou d'interconnexion (21, 20) s'étendant également au moins au voisinage thermoconducteur de la couche (5, 15) faite d'un matériau thermoconducteur diélectrique.

7. - Structure de carte à circuits imprimés (7, 10, 12, 13, 22, 27) selon la revendication 6, **caractérisée par le fait que** le trou d'interconnexion (21, 20) est connecté à une structure de piste conductrice interne (18).

8. - Structure de carte à circuits imprimés (7, 10, 12, 13, 22, 27) selon l'une des revendications 6 ou 7, **caractérisée par le fait que** le trou d'interconnexion (21, 20) passe d'une couche conductrice externe (14) sur un côté d'une carte à circuits imprimés (16) à une couche conductrice externe (17) sur le côté situé à l'opposé de la carte à circuits imprimés (16).

9. - Structure de carte à circuits imprimés (7, 10, 12, 13, 22, 27) selon l'une des revendications 1 à 8, **caractérisée par le fait que** la couche (5, 15) faite d'un matériau thermoconducteur diélectrique remplit des espaces intermédiaires de la structure de piste conductrice interne (3) .
